Europäisches Patentamt

European Patent Office

Office européen des brevets

(11) Veröffentlichungsnummer: **0 278 240**

**A2**

(12) **EUROPÄISCHE PATENTANMELDUNG**

(21) Anmeldenummer: 88100346.1

(22) Anmeldetag: 13.01.88

(51) Int. Cl.⁴: **H01L 23/40 , H05K 7/20**

(30) Priorität: 07.02.87 DE 3703873

(43) Veröffentlichungstag der Anmeldung:
17.08.88 Patentblatt 88/33

(84) Benannte Vertragsstaaten:
**DE FR GB IT**

(71) Anmelder: **Süddeutsche Kühlerfabrik Julius Fr. Behr GmbH & Co. KG**
**Mauserstrasse 3**
**D-7000 Stuttgart 30(DE)**

(72) Erfinder: **Prokopp. Alexander, Dipl.-Ing.**
**Gartenstrasse 23**
**D-7149 Freiberg/N.(DE)**

(74) Vertreter: **Dauster, Hanjörg, Dipl.-Ing. et al**
**WILHELM & DAUSTER Patentanwälte**
**Hospitalstrasse 8**
**D-7000 Stuttgart 1(DE)**

(54) Kühlkörper, insbesondere zum Kühlen elektronischer Bauelemente.

(57) Bei einem Kühlkörper (1),insbesondere zum Kühlen elektronischer Bauelemente (4), mit einem Grundkörper (2) auf dem nebeneinander die Bauelemente (4) und ein die Wärme ableitendes Kühlelementes (3) angeordnet sind, wird eine Vergrößerung der Wärmeübertragungsflächen, bezogen auf das Bauvolumen des Kühlelementes (3) und eine daraus resultierende höhere Kühlleistung, dadurch erreicht, daß das Kühlelement (3) als ein aus einer Vielzahl von Blechen (6) bestehendes Rippenpaket ausgebildet ist. Dabei sind die Bleche (6) im wesentlichen parallel und mit einem aus der Plattendichte des Rippenpakets sich bestimmenden Abstand zueinander angeordnet. Die Bleche (6) sind an einer ihrer Längsseiten (7) miteinander und das Rippenpaket (Kühlelement 3) mit dem Grundkörper (2) stoffschlüssig verbunden. Diese Ausbildung des Kühlkörpers (1) erlaubt eine individuelle Gestaltung des Kühlelements (3) zur optimalen Abfuhr der von den Bauteilen (4) erzeugten Wärme.

Fig. 1

EP 0 278 240 A2

## Kühlkörper, insbesondere zum Kühlen elektronischer Bauelemente

Die Erfindung betrifft einen Kühlkörper, insbesondere zum Kühlen elektronischer Bauelemente, mit einem Grundkörper auf dem nebeneinander die Bauelemente und ein die Wärme ableitendes Kühlelement angeordnet sind.

Derartige Kühlkörper sind bekannt und bestehen in der Regel aus Aluminum-Strangpreßprofilen. Hierbei weist eine als Grundkörper ausgebildete Grundplatte Kühlansätze auf, die als einstückig mit dem Grundkörper verbundene Rippen ausgebildet sind, und das Kühlelement darstellen. Dieser Kühlkörper wird im Strangpreßverfahren hergestellt und ist daher in seiner Gestaltungsmöglichkeit und in seiner Aufnahmevielfalt an Bauelementen begrenzt. Aufgrund des Herstellungsverfahrens sind dünne, hohe Rippen bei gleichzeitig engem Rippenabstand nicht möglich. Dies hat zur Folge, daß derartige Kühlkörper, bezogen auf ihr Bauvolumen, relativ geringe Wärmeübertragungsflächen aufweisen.

Ein anderer bekannter Kühlkörper (DE-OS 35 00 976) sieht vor, daß auf einer Grundplatte mehrere, einen Befestigungsflansch aufweisende Kühlansätze vorgesehen sind. Diese Kühlansätze können z.b. aus dünnen Blechstreifen bestehen, die nebeneinander, im Abstand ihres Befestigungsflansches, über eine Schweißverbindung mit der Grundplatte verbunden sind. Aufgrund der Befestigungsflansche, die wegen der Schweißverbindung eine geeignete Breite aufweisen müssen, können die Kühlansätze nicht beliebig dicht gepackt werden. Dieser Kühlkörper weist außerdem den Nachteil auf, daß die Kühlansätze sukzessive an der Grundplatte zu befestigen sind, was zeitaufwendig und kostenintensiv ist.

Der Erfindung liegt die Aufgabe zugrunde, einen Kühlkörper bereitzustellen, der individuell an die in elektrischen Geräten herrschenden speziellen Kühlprobleme anpaßbar ist und bezogen auf sein Bauvolumen eine relativ große Wärmeübertragungsfläche aufweist, und der einfach zu fertigen ist.

Diese Aufgabe wird erfindungsgemäß dadurch gelöst, daß das Kühelement als ein aus einer Vielzahl von Blechen bestehendes Rippenpaket ausgebildet ist, wobei die Bleche im wesentlichen parallel und mit einem aus der Plattendichte des Rippenpakets sich bestimmenden Abstand zueinander angeordnet sind, diese Bleche an einer ihrer Längsseiten miteinander und das Rippenpaket mit dem Grundkörper stoffschlüssig verbunden sind.

Der erfindungsgemäße Kühlkörper weist einen Grundkörper auf, auf dem, z.b. im Randbereich, die zu kühlenden Bauelemente angeordnet sind. Daneben ist das Kühlelement angeordnet, das stoffschlüssig mit dem Grundkörper verbunden ist. Dieses Kühlelement besteht aus Blechplatten, wobei die einzelnen Platten einen Abstand zueinander aufweisen. Die Bleche können z.B. über eine Lötbrücke o.dgl. gehalten werden, so daß sie sowohl im vorgeschriebenen Abstand zueinander stehen, als auch stoffschlüssig miteinander verbunden sind und ein Rippenpaket, nämlich das Kühlelement bilden. Dieses Rippenpaket ist wiederum stoffschlüssig mit dem Grundkörper verbunden. Durch geeignete Wahl des Abstands der einzelnen Blechplatten, der Dicke der Platten und der Dimensionierung der Plattenflächen kann das Kühelement derart ausgebildet werden, daß es einerseits die erforderliche Grundfläche aufweist, so daß noch genügend Platz zum Befestigen der Bauelemente vorhanden ist, andererseits die erforderliche Wärmeübertragungsfläche besitzt, um die von den Bauelementen erzeugte Wärme mit Sicherheit abzuführen. Durch Variation der Anzahl der Bleche, sowie deren Größe, deren Abstand und deren Dicke, wodurch die Blechdichte des Rippenpakets bestimmt wird, ist eine optimale Auslegung des Kühlelements leicht möglich.

Die stoffschlüssige Verbindung des Kühlelements mit dem Grundkörper hat neben den Vorzügen anderer unlösbarer Verbindungen den Vorteil, daß der ganze Kühlkörper die Wärmeleiteigenschaften eines einstückigen Körpers besitzt. Zwischen dem Grundkörper und dem Kühlelement bestehen keine Hohlräume oder wärmeisolierende Einlagerungen, die den Wärmefluß behindern könnten.

Ein einfaches Variieren des Abstands der einzelnen Bleche wird dadurch erreicht, daß zwischen den Blechen die Spaltbreite bestimmende Zwischenbleche vorgesehen sind. Die Dicke der Zwischenbleche bestimmen den Abstand der einzelnen, die Wärme vom Grundkörper ableitenden Bleche.

Bevorzugt sind die Zwischenbleche an einer Längsseite der Bleche angeordnet und stoffschlüssig mit diesen verbunden. Die Bleche können durch Einlegen der Zwischenbleche zum fertigen Kühelement aufgebaut werden, das anschließend nur noch mit dem Grundkörper zu verbinden ist.

Vorteilhaft ist die stoffschlüssige Verbindung eine Lötverbindung, vorzugsweise eine flußmittelfreie Lötverbindung. Durch die Anordnung der Zwischenbleche an einer Längsseite der Bleche und durch stoffschlüssige Verbindung mit diesen, bietet das als Rippenpaket ausgebildete Kühlelement eine geeignete Auflagefläche, über die es mit dem Grundkörper verbunden werden kann. Die flußmittelfreie Lötverbindung bietet den Vorteil, daß sie aufgrund der benetzenden Eigenschaft der Lote und der Saugwirkung der Kapillarspalte eine großflächige Verbindung der einander anliegenden Flächen gewährt. Mittels einer Lötverbindung lassen sich auch Kühlelemente mit großen Abmessungen hohlraum frei und ohne Einlagerungen auf dem Grundkörper festlegen. Der Stoffschluß der einzelnen Bauteile untereinander garantiert einen optimalen Wärmeübergang und Wärmefluß zwischen Grundkörper und Kühlelement. Die Wärmeabgabe erfolgt an einen parallel zu den Blechen gerichteten Luftstrom, der das Kühlelement durchströmt.

Eine bevorzugte Ausführungsform sieht vor, daß das Kühlelement aus L-, T-oder U-förmigen Blechen aufgebaut ist, die im Bereich ihrer Vorsprünge bzw. Querstege, zur Aufnahme weiterer Bauelemente, eine Auflagefläche bildend, über Zwischenbleche stoffschlüssig miteinander verbunden sind. Dabei sind vorteilhaft die zwischen den L-und T-förmigen Blechen angeordneten, und diese auf Abstand haltenden Zwischenbleche im Bereich der Vorsprünge der Bleche vorgesehen, so daß ein massiver Quersteg entsteht. Der dadurch gebildete, von dem Kühlelement abstehende Quersteg kann als weitere Auflagefläche für Bauelemente dienen. Bei einer T-förmigen Ausbildung der Bleche ergeben sich zwei auf gegenüberliegenden Seiten des Kühlelements angeordnete Querstege zur zusätzlichen Aufnahme von Bauelementen. Bei U-förmigen Blechen ergibt sich ein die freien Schenkel der Bleche verbindender massiver Quersteg zur Aufnahme der Bauelemente.

Bei besonderen Einbaubedingungen kann es vorteilhaft sein, daß die Bleche schräg zu den Kanten des Grundkörpers angeordnet sind. Durch die Schrägstellung der Bleche, wobei diese weiterhin parallel zueinander stehen, kann der Kühlkörper z.b. an eine vorgegebene Luftführung in einer elektronischen Geräteeinheit angepaßt werden, so daß weiterhin eine hohe Wärmeabfuhr erzielt wird.

Eine weitere bevorzugte Ausführungsform sieht vor, daß das Kühlelement Teil eines aus einer Vielzahl von L-, T-oder kreuzförmigen Blechen bestehendes Rippenpaket ist, wobei die Bleche im wesentlichen parallel und in ihrem die Vorsprünge aufweisenden Bereich über Zwischenbleche miteinander stoffschlüssig verbunden sind, und die miteinander über die Zwischenbleche verbundenen Vorsprünge den die Bauelemente aufnehmenden Grundkörper und das restliche Rippenpaket das Kühlelement bilden. Der Grundkörper wird nunmehr von den Vorsprüngen, die über die Zwischenbleche miteinander verbunden sind, gebildet. Durch Anset zen weiterer Zwischenbleche an die beiden äußersten Bleche kann ein umlaufender, die Bauelemente aufnehmender Rand gebildet werden. Im Falle der kreuzförmigen Bleche erstreckt sich das Kühlelement zu beiden Seiten des Grundkörpers.

Eine andere Ausführungsform sieht vor, daß die Bleche als wenigstens ein Wellrippenband ausgebildet sind. Dieses Wellrippenband weist den Vorteil auf, daß es sofort mit dem Grundkörper verbindbar ist, da die einzelnen parallelen Blechabschnitte bereits mit Abstand zueinander stehen. Dieses Wellrippenband wird derart auf dem Grundkörper festgelegt, daß es mit seinen Wellenbögen an dem Grundkörper anliegt, so daß der Luftstrom ungehindert zwischen den einzelnen Blechabschnitten hindurchtreten kann. Wellrippenband und Grundkörper sind stoffschlüssig miteinander verbunden. Eine Erhöhung des Wärmeflusses wird dadurch bewirkt, daß die Keilspalte zwischen den Wellenbögen und dem Grundkörper mit Lot ausgefüllt sind.

Zur Steigerung der Wärmeabgabe werden zwei oder mehrere Wellrippenbänder vorgesehen. Dabei ist es vorteilhaft, daß ein Wellrippenband an der dem Grundkörper abgewandten Seite ein Deckblech aufweist, auf dem ein weiteres Wellrippenband angeordnet ist. Eine weitere Erhöhung der Wärmeabgabe wird durch Anbringen weiterer Wellrippenbänder erreicht, die übereinander angeordnet sind, derart, daß zwischen ihnen lediglich ein Deckblech vorgesehen ist, das zur Wärmeleitung innerhalb des Kühlelements dient und das aufgesetzte Wellrippenband trägt.

Vorteilhaft sind der Grundkörper und/oder die Deckbleche mit Lotmittel plattiert bzw. tragen eine Lötfolie.

Ein kompakter Kühlkörper wird dadurch erreicht, daß der Grundkörper allseitig das Kühlelement überragt. Die Baulemente können sowohl auf der das Kühlelement tragenden Seite als auch auf der Gegenseite vorgesehen sein. Weiterhin kann der Grundkörper entweder mit einem auf einer Seite angeordneten Kühlelement versehen sein, oder es können beide Seiten Kühlelemente tragen. Ggf. kann das Kühlelement das bzw. die Bauteile auch umrahmen.

Weitere Einzelheiten und Merkmale der Erfindung ergeben sich aus der nachfolgenden Beschreibung, in der unter Bezugnahme auf die Zeichnung zwei Ausführungsbeispiele näher beschrieben sind. Dabei zeigen:

Fig. 1 eine perspektivische Ansicht eines L-förmig ausgebildeten Kühlkörpers;

Fig. 2 eine perspektivische Ansicht eines Kühlkörpers mit T-förmigen Blechen und einem aus den Zwischenblechen und den Vorsprüngen der Bleche gebildeten umlaufenden Rand;

Fig. 3 eine perspektivische Ansicht eines Kühlkörpers mit kreuzförmigen Blechen;

Fig. 4 eine Seitenansicht eines Kühlkörpers mit mehreren Wellrippenbändern und

Fig. 5 eine Draufsicht auf den Kühlkörper gemäß Fig. 4.

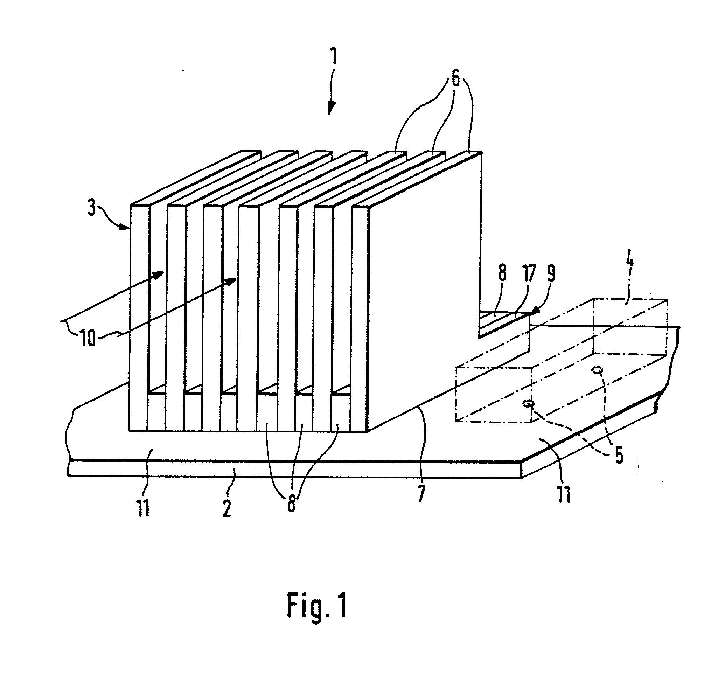

Die Fig. 1 zeigt einen Kühlkörper (1), bestehend aus einem Grundkörper (2) und einem darauf angeordneten Kühlelement (3). Neben dem Kühlelement (3) ist auf dem Grundkörper (2) ein andeutungsweise gezeigtes elektronisches Bauelement (4) angeordnet, dessen Anschlußleitungen durch Bohrungen (5) geführt sind. Das Kühlelement (3) besteht aus L-förmigen Blechen (6), die parallel und mit Abstand zueinander angeordnet sind. Im Bereich der dem Grundkörper (2) zugewandten Stirnseite (7) sind zwischen den Blechen (6) Zwischenbleche (8) vorgesehen, die eine der Länge der Stirnseite (7) entsprechende Länge aufweisen. Ihre Höhe entspricht in diesem Ausführungsbeispiel der Höhe des von den L-förmigen Blechen (6) gebildeten Querstegs (9). Die Zwischenbleche (8) können aber auch derart ausgebildet sein, daß sie lediglich im Bereich des Querstegs (9) dessen Höhe aufweisen, ansonsten jedoch mit einer geringeren bzw. einer größeren Höhe ausgestattet sind. Vorteilhaft können auf der vom Quersteg (9) gebildeten Fläche weitere Bauelemente angeordnet werden, die nunmehr direkt mit dem Kühlelement (3) verbunden sind. Falls aus wärmetechnischen Gründen der Steg (9) nicht notwendig ist, können die Vorsprünge (17) entfallen.

Die in Richtung der Pfeile (10) strömende Luft durchtritt die Bleche (6) unter Aufnahme von Wärme. Diese Wärme wird von den zu kühlenden Bauelementen (4) an den Grundkörper (2) abgegeben und strömt von diesem in die Bleche (6) des Kühlelements (3). Ein guter Wärmeübergang beim Übertritt von dem Grundkörper (2) in das Kühlelement (3) wird dadurch erreicht, daß das Kühlelement (3) stoffschlüssig mit dem Grundkörper (2) verbunden ist. Hierfür sind die miteinander zu verbindenden Flächen mit Lotmittel plattiert bzw. weisen eine Lötfolie auf. Ebenfalls sind die einander anliegenden Flächen der Bleche (6) und der Zwischenbleche (8) über eine Verlötung miteinander verbunden. Daraus ergeben sich die gleichen Wärmeleiteigenschaften wie bei einem einstückig ausgebildeten Kühlkörper (1).

Das Kühlelement (3) kann derart geformt sein, daß es mit den elektronischen Bauelementen (4) flächendeckend auf dem Grundkörper (2) sitzt. Dabei ist das Kühlelement (3) vorteilhaft von einem Rand (11) des Grundkörpers (2) umgeben, auf dem die Bauelemente (4) angeordnet sind, die dann auch später in eingebautem Zustand noch leicht zugänglich sind. Es kann auch vorgesehen sein, daß das Bauelement (4) vom Kühlelement (3) umrandet ist, so daß die abzuführende Wärme nach allen Seiten abfließen kann.

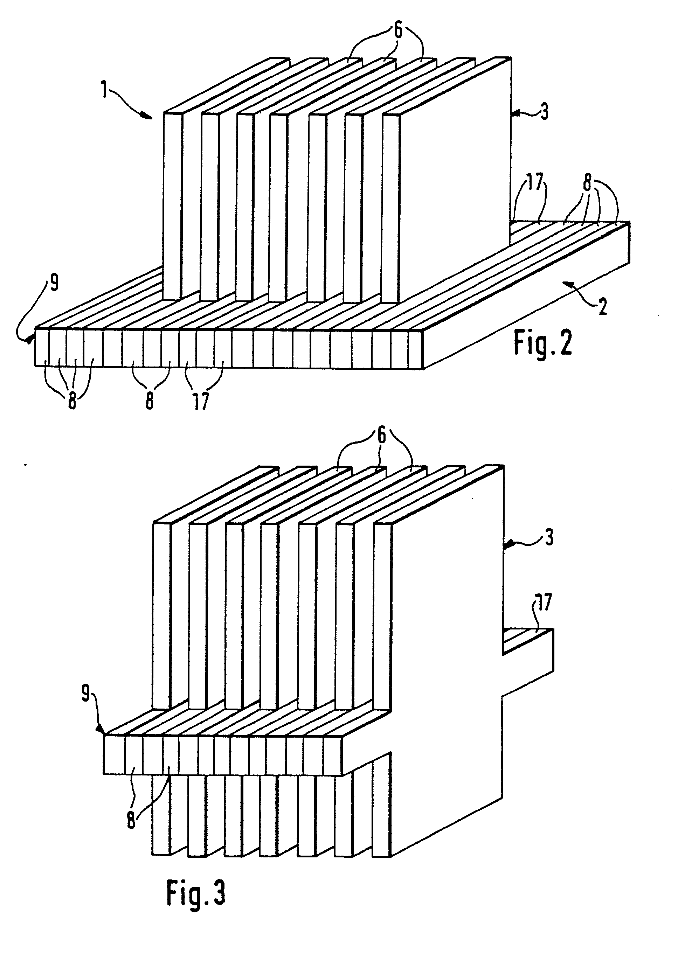

Die Fig. 2 zeigt einen Kühlkörper (1), dessen Kühlelement (3) aus T-förmigen Blechen (6) besteht, die über Zwischenbleche (8) auf Abstand gehalten werden. Diese Zwischenbleche (8) sind derart angeordnet und weisen vorteilhaft eine Größe auf, daß sie mit den zwischen den Zwischenblechen (8) sich befindenden Vorsprüngen (17) der T-förmigen Bleche (6) einen massiven Quersteg (9) bilden. Dieser Quersteg (9) dient als umlaufender Rand zur Aufnahme der Bauelemente (nicht dargestellt). Der Grundkörper (2) wird nunmehr von den Zwischenblechen (8) und den Vorsprüngen (17) der Bleche (6) gebildet wird.

Eine andere, nicht dargestellte Ausführungsform sieht vor, daß die Bleche (6) U-förmig ausgeführt sind und jeweils zwischen den die beiden Schenkel verbindenden Quersteg die Zwischenbleche (8) angeordnet sind. Der Grundkörper (2) besteht nunmehr aus den Zwischenblechen (8) und den Querstegen der U-förmigen Bleche (6).

Fig. 3 zeigt eine Ausführungsform, bei der Bleche (6) kreuzformig gestaltet sind. Dadurch ergibt sich auf beiden Seiten des Blechpakets ein Quersteg (9). Der Kühlkörper (3) erstreckt sich oberhalb und unterhalb der Ebene der Querstege.

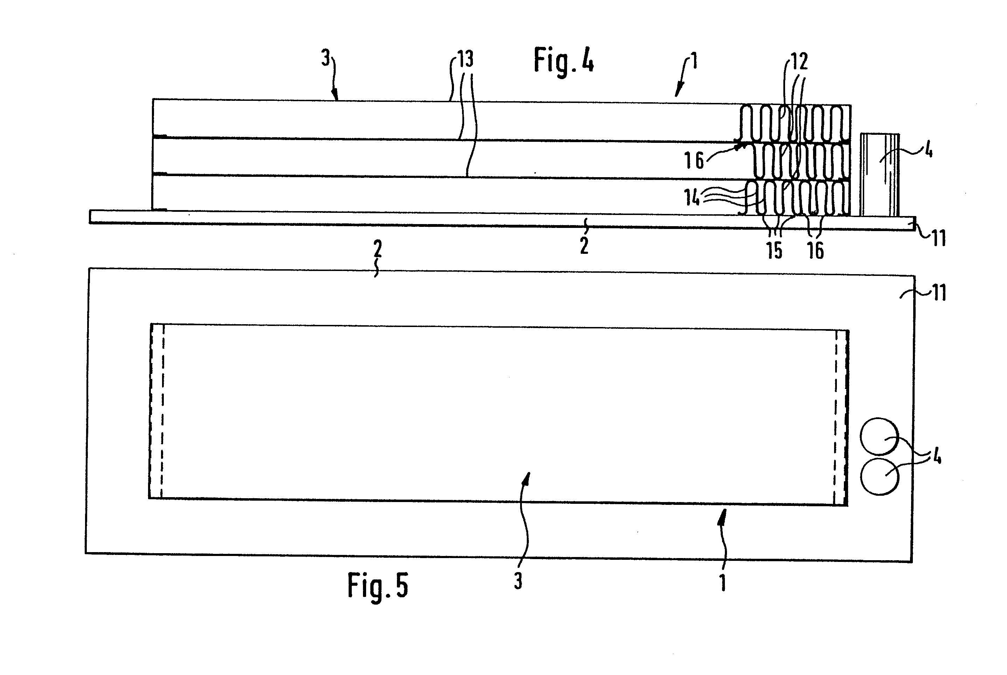

Bei dem in Fig. 4 dargestellten Kühlkörper (1) sind auf einem Grundkörper (2) Wellrippenbänder (12) angeordnet, die das Kühlelement (3) bilden. Die Wellrippenbänder (12) bestehen aus einer Vielzahl im wesentlichen paralleler Blechabschnitte (14), die jeweils paarweise über einen Wellenbogen (15) verbunden sind. Die Anordnung der Wellrippenbänder (12) auf der Oberfläche des Grundkörpers (2) erfolgt derart, daß die Wellenbögen (15) der einen Seite der Bänder (12) auf dem Grundkörper (2) aufliegen und mit diesem z.b. mittels einer Verlötung stoffschlüssig verbunden sind. Um die Wärmeleitung zu erhöhen, sind die Keilspalte (16) beiderseits des Wellenbogens (15) und dem Grundkörper (2) mit Lot ausgefüllt.

Auf dem ersten Wellrippenband (12) ist ein Deckblech (13) vorgesehen, das zum einfachen stoffschlüssigen Befestigen eines weiteren Wellrippenbandes (12) dient. Entsprechend der abzuführenden Wärmemenge kann das Kühlelement (3) aus einem oder mehreren Wellrippenbändern (12) bestehen, die vorteilhaft übereinander angeordnet sind. Eine stoffschlüssige Verbindung wird dadurch erreicht, daß die Deckbleche (13) mit Lotmittel plattiert sind bzw. eine Lötfolie tragen. Die Verlötung erfolgt z.b. flußmittelfrei in einer Lötkammer. Auch die Verbindung zwischen dem Wellrippenband (12) und der Grundplatte (2) erfolgt mittels Lotplattierung bzw. Lötfolie. Auf dem das Kühlelement (3) umgebenden Rand (11) sind die zu kühlenden Bauelement (4) angeordnet, die auch bei dieser Ausführungsform in eingebautem Zustand leicht zugänglich sind.

## Ansprüche

1. Kühlkörper, insbesondere zum Kühlen elektronischer Bauelemente, mit einem Grundkörper auf dem nebeneinander die Bauelemente und ein die Wärme ableitendes Kühlelement angeordnet sind, dadurch gekennzeichnet, daß das Kühlelement (3) als ein aus einer Vielzahl von Blechen (6) bestehendes Rippenpaket ausgebildet ist, wobei die Bleche (6) im wesentlichen parallel und mit einem aus der Plattendichte des Rippenpakets sich bestimmenden Abstand zueinander angeordnet sind, diese Bleche (6) an einer ihrer Längsseiten (7) miteinander und das Rippenpaket (Kühlelement 3) mit dem Grundkörper (2) stoffschlüssig verbunden sind.

2. Kühlkörper nach Anspruch 1, dadurch gekennzeichnet, daß zwischen den Blechen (6) die Spaltbreite bestimmende Zwischenbleche (8) vorgesehen sind.

3. Kühlkörper nach Anspruch 1 oder 2, dadurch gekennzeichnet, daß die Zwischenbleche (8) an einer Längsseite (7) der Bleche (6) angeordnet und stoffschlüssig mit diesen verbunden sind.

4. Kühlkörper nach einem der Ansprüche 1 bis 3, dadurch gekennzeichnet, daß die stoffschlüssige Verbindung eine Lötverbindung, vorzugsweise eine flußmittelfreie Lötverbindung ist.

5. Kühlkörper nach einem der Ansprüche 1 bis 4, dadurch gekennzeichnet, daß das Kühlelement (3) aus L-, T-oder U-förmigen Blechen (6) aufgebaut ist, die im Bereich ihrer Vorsprünge (17) bzw. Querstege zur Aufnahme weiterer Bauelemente (4) eine Auflagefläche bildend über Zwischenbleche (8) stoffschlüssig miteinander verbunden sind.

6. Kühlkörper nach einem der Ansprüche 1 bis 5, dadurch gekennzeichnet, daß die Bleche (6) - schräg zu den Kanten des Grundkörpers (2) angeordnet sind.

7. Kühlkörper, insbesondere zum Kühlen elektronischer Bauelemente, mit einem Grundkörper auf dem nebeneinander die Bauelemente und ein die Wärme ableitendes Kühlelement angeordnet sind, dadurch gekennzeichnet, daß das Kühlelement (3) Teil eines aus einer Vielzahl von L-, T-oder kreuz-förmigen Blechen (6) bestehendes Rippenpaket ist, wobei die Bleche (6) im wesentlichen parallel und in ihrem die Vorsprünge (17) aufweisenden Bereich (9) über Zwischenbleche (8) miteinander stoffschlüssig verbunden sind, und die miteinander über die Zwischenbleche (8) verbundenen Vorsprünge (17) den die Bauelemente (4) aufnehmenden Grundkörper (2) und das restliche Rippenpaket das Kühlelement (3) bilden.

8. Kühlkörper nach Anspruch 1, dadurch gekennzeichnet, daß die Bleche als wenigstens ein Wellrippenband (12) ausgebildet sind.

9. Kühlkörper nach Anspruch 8, dadurch gekennzeichnet, daß das Wellrippenband (12) mit den Wellenbögen (15) am Grundkörper (2) befestigt ist.

10. Kühlkörper nach Anspruch 8 oder 9, dadurch gekennzeichnet, daß der Grundkörper (2) mit mehreren Wellrippenbänder (12) versehen ist, wobei die Wellenrippenbänder (12) an ihrer dem Grundkörper (2) abgewandten Seite Deckbleche (13) aufweisen, auf denen jeweils ein weiteres Wellrippenband (12) angeordnet ist.

11. Kühlkörper nach einem der Ansprüche 1 bis 10, dadurch gekennzeichnet, daß der Grundkörper (2) und/oder die Bleche (8, 13) mit Lotmittel plattiert sind bzw. eine Lötfolie tragen.

12. Kühlkörper nach einem der Ansprüche 8 bis 11, dadurch gekennzeichnet, daß die Keilspalte (16) zwischen den Wellbögen (15) und dem Grundkörper (2) bzw. den Deckblechen (13) mit Lot ausgefüllt sind.

13. Kühlkörper nach einem der Ansprüche 1 bis 12, dadurch gekennzeichnet, daß der Grundkörper (2) allseitig das Kühlelement (3) überragt.

Fig.1

0 278 240

Fig.2

Fig.3

Fig.4

Fig.5

0 278 240